# EUROPÄISCHE PATENTANMELDUNG

(11) **EP 3 879 589 A1**
(43) Veröffentlichungstag der Anmeldung: **15.09.2021**
(21) Anmeldenummer: 21162009.1
(22) Anmeldetag: 11.03.2021
(51) Int. Cl.: H01L 41/047, H01L 41/053, H01L 41/193

(54) **ELEKTROMECHANISCHER WANDLER UND DESSEN VERWENDUNG**

(30) Priorität: 12.03.2020 DE 102020203208
(71) Anmelder: FRAUNHOFER-GESELLSCHAFT zur Förderung der angewandten Forschung e.V., 80686 München (DE)
(72) Erfinder: Böse, Holger, 97082 Würzburg (DE); Liu, Jinchao, 97082 Würzburg (DE)
(74) Vertreter: Pfenning, Meinig & Partner mbB

(57) **Zusammenfassung**

Die vorliegende Erfindung betrifft einen elektromechanischen Wandler mit mindestens einer dielektrischen Elastomerfolie (1), die mindestens eine elektrisch nicht-leitfähige Elastomerschicht (2) und mindestens zwei elektrisch leitfähige Elektrodenschichten (3) aufweist. Weiterhin enthält der Wandler eine flächige Struktur (5) mit Erhöhungen, Vertiefungen oder Öffnungen, sodass der elektromechanische Wandler senkrecht zur Fläche der dielektrischen Elastomerfolie kompressibel ist. Verwendung findet der elektromechanische Wandler insbesondere in Sensoren. Ebenso ist aber auch die Verwendung als Aktor oder als Generator möglich.

## Beschreibung

Die vorliegende Erfindung betrifft einen elektromechanischen Wandler mit mindestens einer dielektrischen Elastomerfolie, die mindestens eine elektrisch nicht-leitfähige Elastomerschicht und mindestens zwei elektrisch leitfähige Elektrodenschichten aufweist. Weiterhin enthält der Wandler eine flächige Struktur mit Erhöhungen, Vertiefungen oder Öffnungen, sodass der elektromechanische Wandler senkrecht zur Fläche der dielektrischen Elastomerfolie kompressibel ist. Verwendung findet der elektromechanische Wandler insbesondere in Sensoren. Ebenso ist aber auch die Verwendung als Aktor oder als Generator möglich.

Die Messung von Drücken oder Druckverteilungen auf ausgedehnten Oberflächen spielt in zahlreichen technischen Systemen eine wichtige Rolle. Eine zusätzliche Anforderung kann darin bestehen, dass die Oberfläche gekrümmt oder flexibel ist und der Sensor sich dieser Oberfläche anpassen muss. Dies ist besonders in solchen Anwendungen relevant, bei denen der Druck auf eine Oberfläche durch eine Person erzeugt wird.

Ein Beispiel mit großer technischer Bedeutung ist die Sensorik in einem Autositz, mit der die Druckverteilung der darauf sitzenden Person registriert wird. Damit kann nicht nur die Belegung des Sitzes erkannt, sondern auch das Gewicht der Person ermittelt und zusätzlich die Verteilung ihres Gewichtes auf der Sitzfläche erfasst werden. Die Kenntnis dieser Daten hat bei einem Unfall erhebliche Bedeutung für die Ansteuerung des Airbags. Durch eine auf die aktuelle Sitzposition abgestimmte Auslösung des Airbags können u. U. Verletzungen vermieden oder verringert werden.

Ein weiterer wichtiger Anwendungsfall für ein solches Sensorsystem zur Messung der Druckverteilung ist die Auflage einer bewegungsunfähigen Person in einem Bett. Hier ist es notwendig, Stellen mit hoher Druckbelastung des Körpers zu erkennen und gezielt zu entlasten, da andernfalls schwer heilende Wunden entstehen (Dekubitus). Eine ähnliche Situation ergibt sich für einen Querschnittsgelähmten auf der Sitzfläche seines Rollstuhls. Weiterhin ist es beispielsweise für Diabetes-Patienten sehr wichtig, beim Stehen die Druckverteilung des Fußes im Schuh zu erfassen, da auch hier schwere Schäden bis hin zu einer notwendigen Amputation entstehen können.

Darüber hinaus existieren zahlreiche weitere bedeutende Anwendungen für flexible Drucksensoren. So ist es wichtig, den Anpressdruck einer Elastomer-Dichtung messen zu können, um bei nachlassendem Druck etwaige Leckagen rechtzeitig zu erkennen. Bei einem Schlauch, der von einer Flüssigkeit oder einem Gas durchströmt wird, soll der Druck dieses Mediums bestimmt werden. Ebenso ergeben sich wesentliche Vorteile daraus, bei einem Gummilager die auftretenden Belastungen und ihre Änderungen jederzeit messen zu können, um den Betriebszustand und mögliche Überlastungen des Lagers zu erfassen. Auch bei diesen Anwendungen kann es sinnvoll sein, nicht nur den Druck an einer Stelle, sondern die Druckverteilung auf einer ausgedehnten Fläche zu messen.

Zu unterscheiden ist zwischen Drucksensoren, die eine hohe Messempfindlichkeit aufweisen (etwa im Druckbereich unter 100 kPa) und solchen Sensoren, die für höhere Drücke ausgelegt sind. In der Erfindung wird der Bereich höhere Drücke adressiert, d. h. die Sensoren weisen keine besonders hohe Empfindlichkeit auf.

US 6,809,462 beschreibt eine dielektrische Elastomerfolie, bestehend aus einer dielektrischen Schicht, die beidseitig von zwei Elektrodenschichten bedeckt wird.

In US 8,272,276 wird eine flexible kapazitive Drucksensormatte beschrieben, bei der elastische Profile beim Zusammendrücken gestaucht werden. Damit kommen sich die außen angebrachten Elektroden näher, wodurch sich die elektrische Kapazität erhöht. Die Drucksensormatte ist als Array ausgelegt, sodass der Druck ortsaufgelöst gemessen werden kann.

EP 2 698 616 beschreibt einen flächigen volumenkompressiblen kapazitiven Sensor zur Messung von Druck und/oder zur Messung oder Detektion von Deformationen. In einer darin beschriebenen Version befindet sich eine dielektrische Elastomerfolie zwischen zwei Profilen, die beim Zusammendrücken der Sensormatte ineinandergreifen, wodurch die dielektrische Elastomerfolie gedehnt wird. Dabei wird das Volumen der vor dem Zusammendrücken der Sensormatte zwischen der dielektrischen Elastomerfolie und den Profilen vorhandenen Hohlräume reduziert.

In CN 104535227 wird ein Drucksensorarray beschrieben, bei dem Erhöhungen auf einer Platte eine dielektrische Elastomerfolie lokal in Öffnungen in einer anderen Platte hineindrücken, wobei die dielektrische Elastomerfolie an diesen Stellen gedehnt wird.

EP 2 899 521 beschreibt eine volumenkompressible kapazitive flächige flexible Sensormatte zur Messung von Druck oder Druckverteilungen und/oder zur Messung oder Detektion von Deformationen. Die Sensormatte besteht aus einer Profilfolie und einer ebenen Folie oder aus zwei Profilfolien. Wenn der Verbund aus den zwei Elastomerfolien, die jeweils eine Elektrode enthalten, zusammengedrückt wird, erhöht sich die Kapazität zwischen den Elektroden. Mindestens eine Elektrode des Kondensators, dessen Kapazität gemessen wird, befindet sich damit auf einer Profilfolie.

EP 2 630 674 beschreibt einen elektroaktiven Elastomerwandler, der aus einem Schichtverbund aus Elastomerschichten und Elektrodenkörpern besteht. Die Elektrodenkörper weisen dabei Ausnehmungen auf, in die das Elastomermaterial bei der Kompression des elektroaktiven Elastomerwandlers verdrängt werden kann.

Für die Messung eines mechanischen Druckes stehen eine große Auswahl von Messmethoden und entsprechende Sensoren zur Verfügung. Wenn jedoch die Druckverteilung auf einer großen Fläche erfasst werden soll, ist dies mit einem hohen Aufwand verbunden, da eine Vielzahl von Sensoren dafür eingesetzt werden muss. Noch schwieriger zu realisieren ist die Druckmessung auf einer flexiblen Unterlage, da die Sensoranordnung der Verformung der Unterlage folgen muss.

Bisher stehen nur wenige Sensorsysteme zur Verfügung, mit denen Druckverteilungen auf flexiblen Unterlagen gemessen werden können. Diese Sensorsysteme sind aber technisch aufwendig und entsprechend sehr teuer und können daher die Anwendungen, die in den vorangehenden Beispielen aufgezeigt wurden, nicht oder nur sehr eingeschränkt bedienen.

Ausgehend hiervon war es Aufgabe der vorliegenden Erfindung, einen elektromechanischen Wandler bereitzustellen, mit dem Druckverteilung auf flexiblen Unterlagen gemessen werden und der gleichzeitig einfach aufgebaut ist.

Diese Aufgabe wird durch den elektromechanischen Wandler mit den Merkmalen des Anspruchs 1 gelöst. Die weiteren abhängigen Ansprüche führen bevorzugte Ausführungsformen auf. In Anspruch 15 werden erfindungsgemäße Verwendungen genannt.

Die Erfindung betrifft einen elektromechanischen Wandler aus einem Elastomerkomposit mit mindestens zwei Elektroden, die einen elektrischen Kondensator bilden.

Der elektromechanische Wandler weist mindestens eine dielektrische Elastomerfolie mit mindestens einer elektrisch nicht-leitfähigen Elastomerschicht und angrenzend an die Oberfläche der Elastomerschicht(en) mindestens zwei elektrisch leitfähige Elektrodenschichten auf. Weiterhin weist der elektromechanische Wandler mindestens eine flächige Struktur auf, die Erhöhungen und/oder Vertiefungen und/oder Öffnungen aufweist und flächig an der dielektrischen Elastomerfolie anliegt. Besonders bevorzugt weist der elektromechanische Wandler mindestens eine flächige Struktur mit Öffnungen auf, die flächig an der mindestens einen dielektrischen Elastomer-folie, insbesondere oberhalb und/oder unterhalb der dielektrischen Elastomerfolie anliegt. Im Falle mehrerer dielektrischer Elastomerfolien liegt die mindestens eine flächige Struktur oberhalb und/oder unterhalb der äußeren dielektrischen Elastomerfolien an. Ebenso kann die mindestens eine flächige Struktur zwischen den dielektrischen Elastomerfolien angeordnet sein.

Zusätzlich weist der Wandler mindestens zwei elektrische Zuleitungen zu den mindestens zwei Elektrodenschichten zur Messung der elektrischen Kapazität auf. Der elektromechanische Wandler ist dabei senkrecht zur Fläche der dielektrischen Elastomerfolie kompressibel, sodass sich über die Kompression die elektrische Kapazität messbar verändert.

Eine Komponente des erfindungsgemäßen elektromechanischen Wandlers ist eine dielektrische Elastomerfolie. Diese dielektrische Elastomerfolie besteht aus einer stark dehnbaren Elastomerfolie als Dielektrikumsschicht, die beidseitig mit ebenfalls stark dehnbaren Elektroden beschichtet ist. Die Elektroden behalten auch bei hoher Dehnung eine ausreichende elektrische Leitfähigkeit bei. Eine solche dielektrische Elastomerfolie hat damit die Form eines Kondensators, dessen Kapazität von der Fläche der Elektroden und der Dicke der dazwischen liegenden Dielektrikumsschicht abhängt. Wird die dielektrische Elastomerfolie gedehnt, so vergrößert sich die Fläche und verringert sich der Elektrodenabstand. Beides führt zu einer Erhöhung der Kapazität. Damit wirkt die dielektrische Elastomerfolie wie ein kapazitiver Dehnungssensor.

Bei der Auflage und Belastung einer dielektrischen Elastomerfolie auf einer nachgiebigen Unterlage wie z. B. einem Sitz, aber auch auf einer harten Unterlage ist die sich einstellende Dehnung der Folie und auch ihre Kompression jedoch sehr klein und damit die Empfindlichkeit der Kapazitätsmessung nur gering. Das hängt damit zusammen, dass die dielektrische Elastomerfolie weitgehend volumeninkompressibel ist. Beim Zusammendrücken der Folie auf einer harten Unterlage mit höherem Druck weicht das Elastomermaterial zur Seite aus, wodurch sich die Folienfläche vergrößert. Dies ist jedoch mit einem hohen mechanischen Widerstand durch die Reibung auf der Unterlage verbunden, d. h. der Sensor reagiert auf den mechanischen Druck auf die Folie sehr unempfindlich. Hinzu kommt, dass bei der Entlastung des Sensors die hohe Reibung eine Rückstellung der Verformung weitgehend verhindert. Damit entsteht eine sehr große Hysterese der Kennlinie des Sensors, d. h. die Messkurven der Kapazität in Abhängigkeit vom Belastungsdruck bei Belastung und Entlastung des Sensors fallen weit auseinander. Die vorliegende Erfindung stellt eine Lösung bereit, mit der sich die dielektrische Elastomerfolie leichter komprimieren lässt, die Kapazitätserhöhung bei mechanischer Belastung damit höher ausfällt und die Hysterese deutlich kleiner ist, weil sich die Verformung des Sensors bei der Entlastung leichter zurückstellt.

Hierzu wird die dielektrische Elastomerfolie mit mindestens einer flächigen Struktur mit Vertiefungen und/oder Erhöhungen auf ihrer Oberfläche auf der der dielektrischen Elastomerfolie zugewandten Seite und/oder mit durch die Struktur durchgehenden Öffnungen flächig verbunden. Die flächige Struktur ist dabei bevorzugt als Platte oder Folie ausgebildet. Bei einer Druckausübung auf diesen Verbund aus dielektrischer Elastomerfolie und flächiger Struktur mit Vertiefungen und/oder Erhöhungen und/oder Öffnungen kann die dielektrische Elastomerfolie in ihrer Dicke leichter komprimiert werden, da das verdrängte Elastomermaterial in die Vertiefungen und/oder Öffnungen ausweichen und/oder das durch die Erhöhungen lokal komprimierte Elastomermaterial nun zur Seite ausweichen kann. Ohne die flächige Struktur mit Vertiefungen und/oder Erhöhungen und/oder Öffnungen kann es dagegen nur nach außen ausweichen, wird aber wegen der Reibung auf der Unterlage an der Ausdehnung bei der Belastung und vor allem an der Rückstellung bei der Entlastung behindert. Durch die Hinzufügung der flächigen Struktur mit Vertiefungen und/oder Erhöhungen wird damit die Messempfindlichkeit der dielektrischen Elastomerfolie als kapazitiver Drucksensor deutlich gesteigert und die Hysterese zwischen Belastungs- und Entlastungskurve erheblich reduziert.

Die Kapazitätserhöhung des elektromechanischen Wandlers kann mit einem einfachen Messverfahren erfasst werden. Hierzu werden beispielsweise Mikroprozessoren eingesetzt, die für Kapazitätsmessungen bereits ausgelegt sind.

Die Wirkung des elektromechanischen Wandlers besteht darin, dass damit Drücke oder Druckverteilungen auch großflächig gemessen werden können. Ein besonderer Vorteil ist die Flexibilität, da sich damit auch Druckverteilungen auf verformbaren Unterlagen wie Sitzflächen oder Betten ermitteln lassen. Weitere Vorteile sind der einfache Aufbau, die wenig aufwendige Messelektronik und die damit verbundenen relativ niedrigen Herstellungskosten, die den elektromechanischen Wandler auch für sensorische Massenanwendungen nutzbar machen. Zusätzlich kann der elektromechanische Wandler auch als Aktor oder Generator genutzt werden.

Eine bevorzugte Ausführungsform sieht vor, dass die mindestens eine dielektrische Elastomerfolie mehr als eine elektrisch nicht-leitfähige Elastomerschicht und mehr als zwei elektrisch leitfähige Elektrodenschichten in alternierender Schichtfolge aufweist. Hierdurch kann die Kapazität bei gleichbleibender Fläche erhöht werden.

Befindet sich eine dielektrische Elastomerfolie zwischen zwei Strukturen mit Vertiefungen und/oder Erhöhungen und/oder Öffnungen, so ist es bevorzugt, dass sich die gegenüberliegenden Vertiefungen zumindest teilweise überdecken und/oder die gegenüberliegenden Erhöhungen zumindest teilweise überdecken und/oder die Öffnungen zumindest teilweise überdecken. Im Gegensatz zu EP 2 698 616 handelt es sich dann nicht um komplementäre Profile, bei denen bei der Kompression die Erhöhungen des einen Profils in die Vertiefungen des anderen Profils und umgekehrt eindringen und dabei die dielektrische Elastomerfolie dehnen. Um die Dicke des Drucksensors gering zu halten, ist die Dicke einer Struktur mit Vertiefungen und/oder Erhöhungen und/oder die Öffnungen vorzugsweise nicht größer als die Dicke der dielektrischen Elastomerfolie.

Besonders vorteilhaft ist es, wenn die leitfähigen Elektrodenschichten sich nicht über die gesamte Fläche der dielektrischern Elastomerfolie erstrecken, sondern bevorzugt auf den Flächensegmenten Aussparungen aufweisen, auf denen die dielektrische Elastomerfolie die flächige Struktur mit Vertiefungen und/oder Erhöhungen und/oder Öffnungen nicht berührt. Damit erfolgt die Kompression der dielektrischen Elastomerfolie vorwiegend auf den Flächensegmenten, die von Elektrodenschichten bedeckt sind, wodurch die relative Kapazitätserhöhung bei der Kompression des elektromechanischen Wandlers größer ausfällt.

Damit ergeben sich umfangreiche Möglichkeiten, die Empfindlichkeit und die Kennlinie des Drucksensors (Kapazität vs. Druck) bedarfsgerecht einzustellen.

Vorzugsweise enthält oder besteht die Struktur mit Vertiefungen und/oder Erhöhungen und/oder Öffnungen aus einem Kunststoff oder einem Elastomer. Das Material der Struktur mit Vertiefungen und/oder Erhöhungen und/oder Öffnungen weist vorzugsweise eine höhere Härte bzw. einen höheren E-Modul auf als die Elastomerschicht in der dielektrischen Elastomerfolie, damit die Verformung bei Druck überwiegend in der dielektrischen Elastomerfolie erfolgt. Handelt es sich um elastomere Materialien so kann die Härte als Shore-Härte nach ISO 7619-1 gemessen werden, bei nicht-elastomeren Materialien kann die Kunststoffhärte nach Rockwell mit ISO 2039-2 bestimmt werden. Vickers-Härte.

Die Vertiefungen und/oder Erhöhungen und/oder Öffnungen in der Struktur können unterschiedliche Formen aufweisen. Sie können bevorzugt kreisförmig, oval, rechteckig oder langgestreckt sein. Sie befinden sich entweder nur auf einer Seite der Struktur oder auf beiden Seiten. Handelt es sich um Öffnungen, die durch die Platte/Folie hindurchgehen, kann die Größe und Form der Öffnung auf beiden Seiten unterschiedlich sein. Auch können sich auf einer Struktur verschiedene Arten von Vertiefungen und/oder Erhöhungen und/oder Öffnungen auf derselben Seite befinden.

Eine bevorzugte Ausführungsform sieht vor, dass sich die Erhöhungen und/oder Vertiefungen auf einer oder beiden Oberflächen der Struktur befinden.

Vorzugsweise weist die mindestens eine Elastomerschicht eine Dicke von 0,1 nm bis 5 mm, bevorzugt von 1 nm bis 2 mm und besonders bevorzugt von 5 nm bis 1 mm auf. Die mindestens zwei elektrisch leitfähigen Elektrodenschichten haben vorzugsweise jeweils eine Dicke von 0,1 nm bis 100 µm, bevorzugt von 1 nm bis 50 µm und besonders bevorzugt von 5 nm bis 30 µm.

Damit hängen die Kompressibilität des Drucksensors, d. h. die Abhängigkeit der Gesamtdicke des Schichtverbundes aus dielektrischer Elastomerfolie und Struktur mit Vertiefungen und/oder Erhöhungen und/oder Öffnungen von der angelegten Druckstärke, und die Rückstellbarkeit bei der Druckentlastung von verschiedenen Parametern ab:
- der Härte der in der dielektrischen Elastomerfolie verwendeten Elastomere,
- der Anzahl und Dicke der einzelnen Dielektrikums- und Elektrodenschichten in der dielektrischen Elastomerfolie,
- der Härte und Dicke der Platte/Folie mit Vertiefungen und/oder Erhöhungen und/oder Öffnungen,
- der Anzahl, Anordnung, Größe und Form der Vertiefungen und/oder Erhöhungen und/oder Öffnungen.

Die Struktur sollte vorzugsweise auf beiden Seiten eine ebene Oberfläche aufweisen, die von 10 % bis 90 %, bevorzugt von 20 % bis 80 % und besonders bevorzugt von 30 % bis 70 % der Fläche einnimmt. Auf diese ebenen Oberflächen können dann die Vertiefungen und/oder Erhöhungen und/oder Öffnungen bezogen werden. Im Vergleich zu Erhöhungen werden Vertiefungen gegenüber der ebenen Oberfläche bevorzugt, da dann der gesamte Sensor eine geringere Dicke aufweist. Besonders bevorzugt werden durchgehende Öffnungen durch die Struktur, da dadurch der Luftdruck- und Feuchtigkeitsausgleich erleichtert wird.

Es ist bevorzugt, dass alle Erhöhungen und/oder Vertiefungen und/oder Öffnungen in der mindestens einen Struktur zusammen ein Volumen einnehmen, das von 10 % bis 90 %, bevorzugt von 20 % bis 80 % und besonders bevorzugt von 30 % bis 70 % des Volumens der an die Struktur Folie angrenzenden dielektrische Elastomerfolie beträgt.

Die äußeren Elektrodenschichten auf der dielektrischen Elastomerfolie sind vorzugsweise noch mit jeweils einer nichtleitfähigen Elastomer-Schutzschicht beschichtet. Damit werden die äußeren Elektrodenschichten, die sich sonst im Kontakt mit den Vertiefungen und/oder Erhöhungen und/oder die Öffnungen auf der Struktur befinden, bei der Kompression vor Abrieb geschützt. Außerdem kann die Struktur mit Vertiefungen und/oder Erhöhungen und/oder die Öffnungen dann auch leitfähig sein und damit zur elektrischen Abschirmung der dielektrischen Elastomerfolie dienen.

Es ist bevorzugt, dass die Elastomerschicht in der dielektrischen Elastomerfolie Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), einen Fluorkautschik wie Viton, ein thermoplastisches Elastomer wie thermoplastische Styrol-Copolymere (Styrol-Butadien-Styrol- (SBS-), Styrol-Ethylen-Butadien-Styrol- (SEBS-), Styrol-Ethylen-Propylen-Styrol- (SEPS-), Styrol-Ethylen-Ethylen-Propylen-Styrol- (SEEPS-) oder Styrol-Isopren-Styrol- (SIS-) Copolymer), teilvernetzte Blends auf Polyolefin-Basis (aus Ethylen-Propylen-Dien-Kautschuk und Polypropylen (EPDM/PP), aus Nitril-Butadien-Kautschuk und Polypropylen (NBR/PP) oder aus Ethylen-Propylen-Dien-Kautschuk und Polyethylen(EPDM/PE)) oder thermoplastische Urethan-Copolymere (aromatisches Hartsegment und Ester-Weichsegmernt (TPU-ARES), aromatisches Hartsegment und Ether-Weichsegment (TPU-ARET) oder aromatisches Hartsegment und Ester/Ether-Weichsegment (TPU-AREE)) enthält oder daraus besteht.

Weiter ist es bevorzugt, dass die Elastomerschicht in der dielektrischen Elastomerfolie elektrisch polarisierbare Partikel wie Bariumtitanat, Bleizirkonattitanat oder Titandioxid und/oder elektrisch leitfähige Partikel aus Kohlenstoff wie Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen oder eine organische Modifizierung zur Erhöhung der Permittivität enthält.

Es ist bevorzugt, dass die leitfähigen Elektrodenschichten in der dielektrischen Elastomerfolie leitfähige Partikel aus Kohlenstoff wie Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen enthalten.

Eine bevorzugte Ausführungsform sieht vor, dass der elektromechanische Wandler mindestens zwei dielektrische Elastomerfolien aufweist, zwischen denen eine flächig an den dielektrischen Elastomerfolien anliegende Struktur mit Erhöhungen und/oder Vertiefungen und/oder Öffnungen angeordnet ist.

Vorzugsweise ist die Dicke der mindestens einen Erhöhungen und/oder Vertiefungen und/oder Öffnungen aufweisenden Struktur kleiner oder gleich der Dicke der mindestens einen dielektrischen Elastomerfolie.

Der elektromechanische Wandler kann vorzugsweise auch mehr als eine Struktur mit Vertiefungen und/oder Erhöhungen und/oder Öffnungen enthalten, z. B. zwei Strukturen mit Vertiefungen und/oder Erhöhungen und/oder Öffnungen auf beiden Seiten der dielektrischen Elastomerfolie oder auch weitere Strukturen mit Vertiefungen und/oder Erhöhungen und/oder Öffnungen zwischen jeweils zwei dielektrischen Elastomerfolien.

Durch eine Strukturierung der Elektrodenfelder in der dielektrischen Elastomerfolie wird außerdem erreicht, dass der anliegende Druck ortsaufgelöst an verschiedenen Stellen gemessen werden kann. Auf diese Weise entsteht ein ein- oder zweidimensionales Sensorarray oder eine andere, z. B. unregelmäßige, Anordnung von mehreren Sensorflächen. Durch eine zeilen- und spaltenweise Anordnung der beiden komplementären Elektroden eines zweidimensionalen Sensorarrays kann die Kontaktierung für ein Multiplexing vereinfacht werden.

Der Wandler kann vorzugsweise als Sensor, insbesondere Drucksensor eingesetzt werden. Er wird hierzu bevorzugt flexibel ausgelegt, kann aber auch einen starren Aufbau haben. Bei der Ausübung von Druck auf den Sensor ändert sich die elektrische Kapazität zwischen den Elektroden messbar, sodass aus der Kapazitätsänderung der Druck ermittelt wird.

Insbesondere bietet sich der erfindungsgemäße elektromechanische Wandler für folgende Anwendungsgebiete an:
- Messung des Anpressdruckes von Dichtungen
- Druckmessung in Schläuchen
- Auflastmessung auf Gummilagern
- Registrierung der Sitzbelegung, des Gewichtes und der Sitzposition von Fahrzeuginsassen im Automobil zur Steuerung des Airbags u.a.
- Erfassung der Druckverteilung von bewegungsunfähigen bettlägerigen Patienten zur Verhinderung von schwer heilenden Wunden (Dekubitus)
- Messung der Druckverteilung von querschnittsgelähmten Personen beim Sitzen im Rollstuhl zur Vermeidung von Wunden
- Detektion der Druckverteilung im Schuh, z. B. bei Diabetes-Patienten oder auch für orthopädische Analysen
- Sensorflächen auf Fußböden zur Detektion von darauf tretenden Personen für Sicherheitszwecke
- Predictive Maintenance von Elastomerbauteilen
- Überwachung der Druckentwicklung in Batteriezellen
- Flexible Waagen oder andere flexible Drucksensoren

Daneben kann der elektromechanische Wandler auch als Aktor genutzt werden. Hierzu wird der Aktor mit einem Gewicht belastet. Durch Anlegen einer elektrischen Spannung zwischen den Elektroden zieht sich Aktor in seiner Höhe zusammen und das Gewicht wird abgesenkt. Beim Abschalten der Spannung wird das Gewicht durch die elastische Rückstellung wieder angehoben.

Schließlich kann der elektromechanische Wandler auch als Generator eingesetzt werden, der mechanische Energie in elektrische Energie umwandelt. Hierzu wird der Generator periodisch durch Druck belastet und wieder entlastet. Während einer Periode wird elektrische Energie durch Aufladen des Kondensators eingebracht und eine größere Menge elektrischer Energie aus dem Kondensator entnommen. Die Differenz der beiden elektrischen Energiemengen entsteht aus der Umwandlung von mechanischer in elektrische Energie.

Anhand der nachfolgenden Figuren und Beispiele soll der erfindungsgemäße Gegenstand näher erläutert werden, ohne diesen auf die hier gezeigten spezifischen Ausführungsformen einschränken zu wollen.

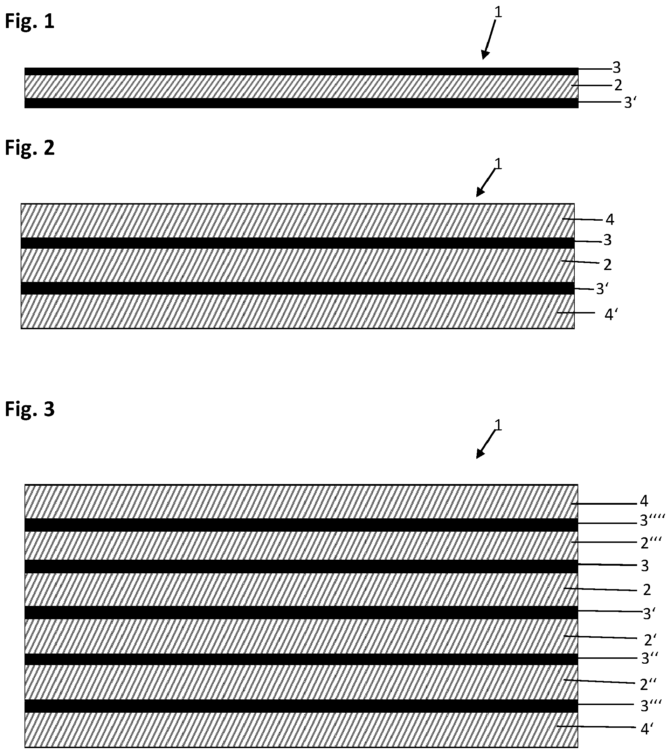

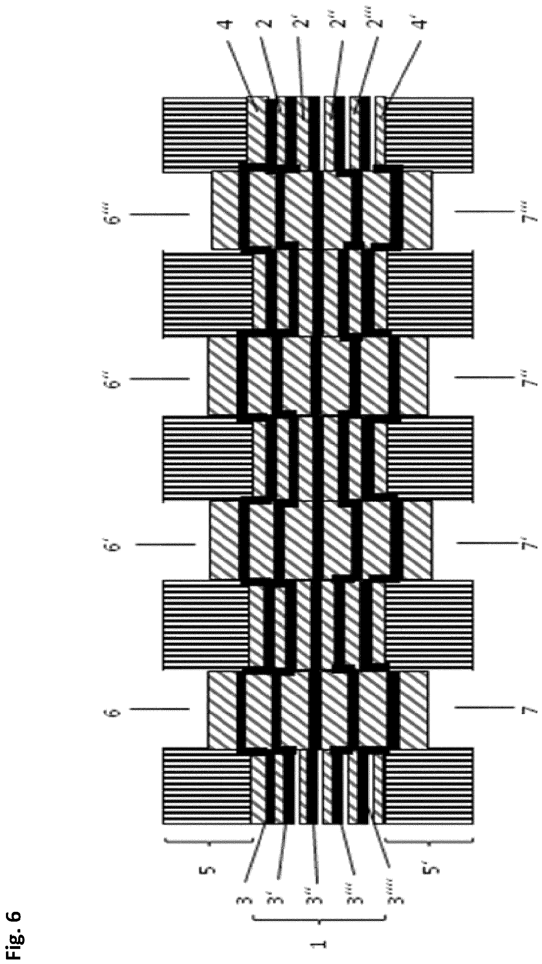

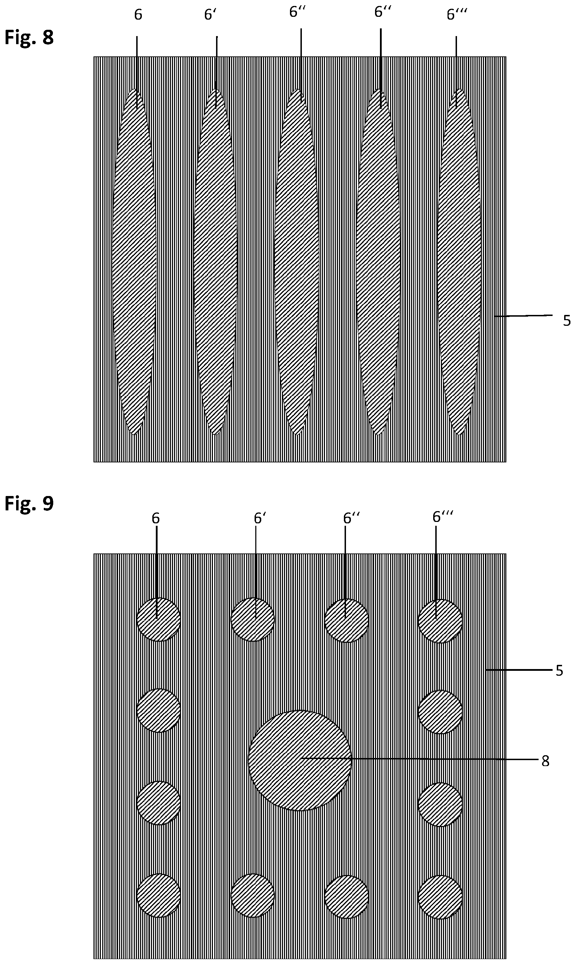

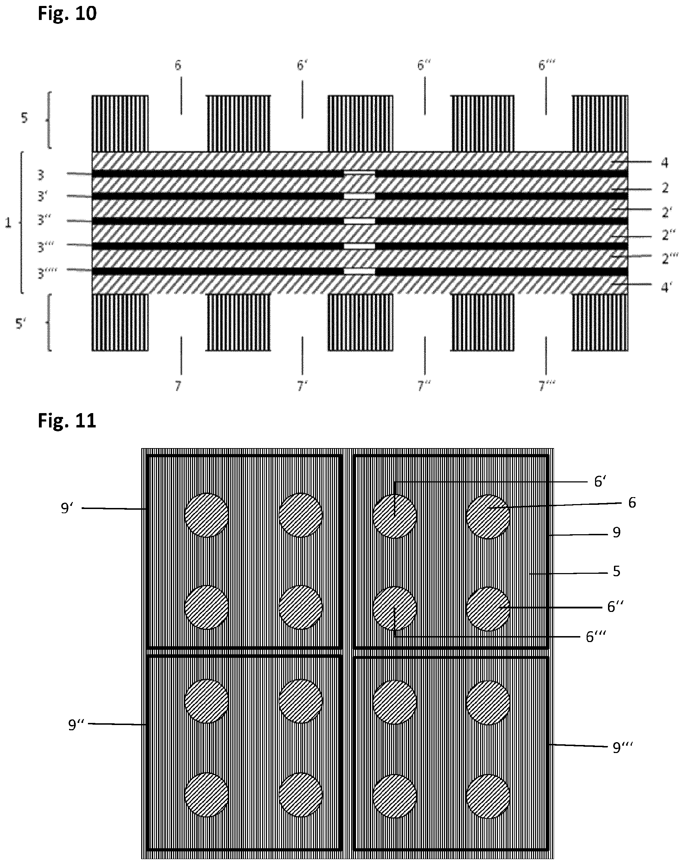

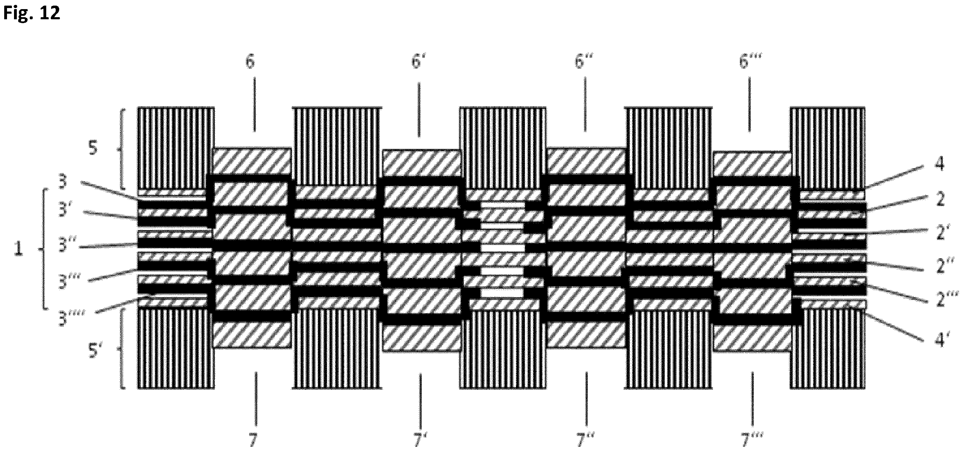

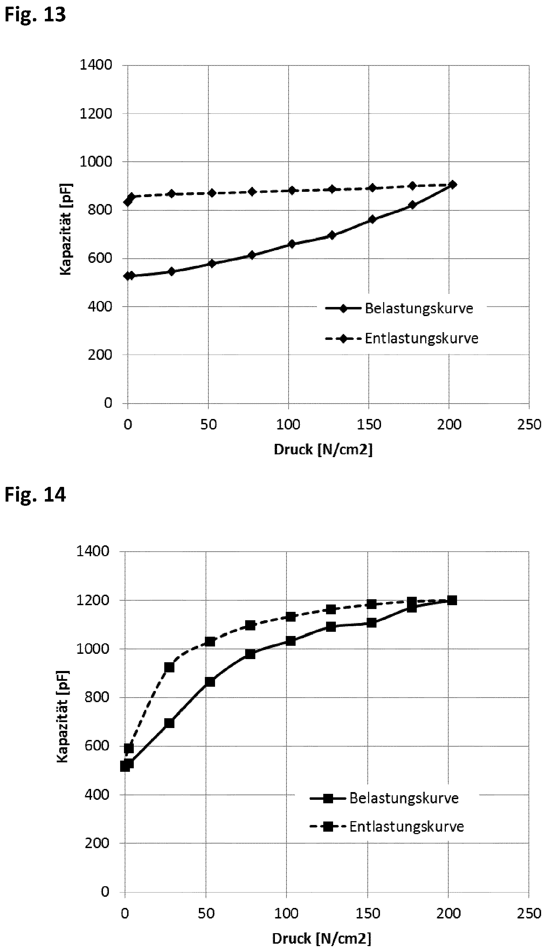

Die Figuren 1 bis 3 zeigen verschiedene Versionen von dielektrischen Elastomerfolien aus dem Stand der Technik. Die Figuren 4 bis 14 betreffen erfindungsgemäße Ausführungsformen.

### Vergleichsbeispiele des Standes der Technik

In Fig. 1 ist eine aus dem Stand der Technik bekannte dielektrische Elastomerfolie 1 dargestellt, die eine Elastomerschicht 2 und zwei Elektrodenschichten 3, 3' aufweist.
Fig. 2 zeigt eine weitere aus dem Stand der Technik bekannte dielektrische Elastomerfolie 1 mit einer Elastomerschicht 2, zwei die Elastomerschicht 2 einschließende Elektrodenschichten 3, 3', die wiederum von zwei Schutzschichten 4, 4' umgeben sind.
Fig. 3 zeigt eine weitere aus dem Stand der Technik bekannte dielektrische Elastomerfolie 1 mit vier Elastomerschichten 2, 2', 2", 2''', die durch Elektrodenschichten 3, 3', 3" getrennt sind. Die äußeren Elastomerschichten sind von Elektrodenschichten 3"', 3"" und zwei Schutzschichten 4, 4' umgeben.

### Erfindungsgemäßes Beispiel 1

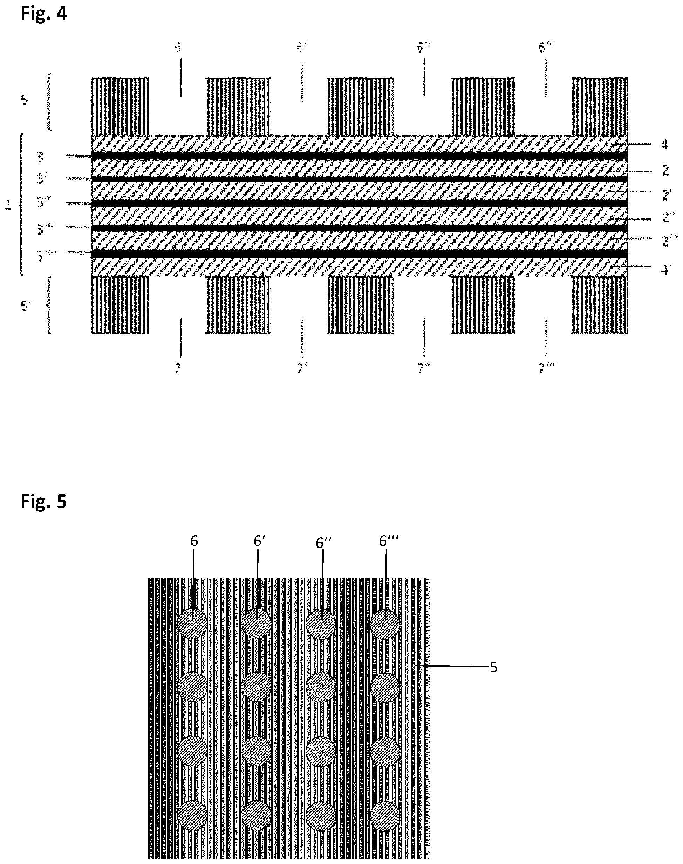

Figur 4 zeigt im Querschnitt den Aufbau eines erfindungsgemäßen elektromechanischen Wandlers mit einer dielektrischen Elastomerfolie 1, bestehend aus fünf leitfähigen Elektrodenschichten 3, 3', 3", 3"', 3"" und vier zwischen den Elektrodenschichten angeordneten nicht-leitfähigen Elastomerschichten 2, 2', 2", 2'" und zwei nicht-leitfähigen Schutzschichten 4, 4', die die äußeren Elektrodenschichten 3 und 3"" einschließen. Weiterhin weist der elektromechanische Wandler zwei Strukturen 5, 5'mit kreisförmigen oberen Öffnungen 6, 6', 6", 6''' und unteren Öffnungen 7, 7', 7", 7''' auf. Anstatt der Öffnungen können die Strukturen 5, 5' auch entsprechende Erhöhungen oder Vertiefungen aufweisen.
Figur 5 zeigt den erfindungsgemäßen elektromechanischen Wandler aus Figur 4 in der Aufsicht, aus der die oberen Öffnungen 6, 6', 6", 6''' in der Struktur 5 zu erkennen sind.
Figur 6 zeigt im Querschnitt den erfindungsgemäßen elektromechanischen Wandler aus Figur 4 im komprimierten Zustand. Hier ist zu erkennen, dass sich die dielektrische Elastomerfolie in die Öffnungen 6, 6', 6", 6''' in der Struktur 5 sowie 7, 7', 7", 7''' in der Struktur 5' ausbreitet und zwischen den Öffnungen dünner wird.

### Erfindungsgemäßes Beispiel 2

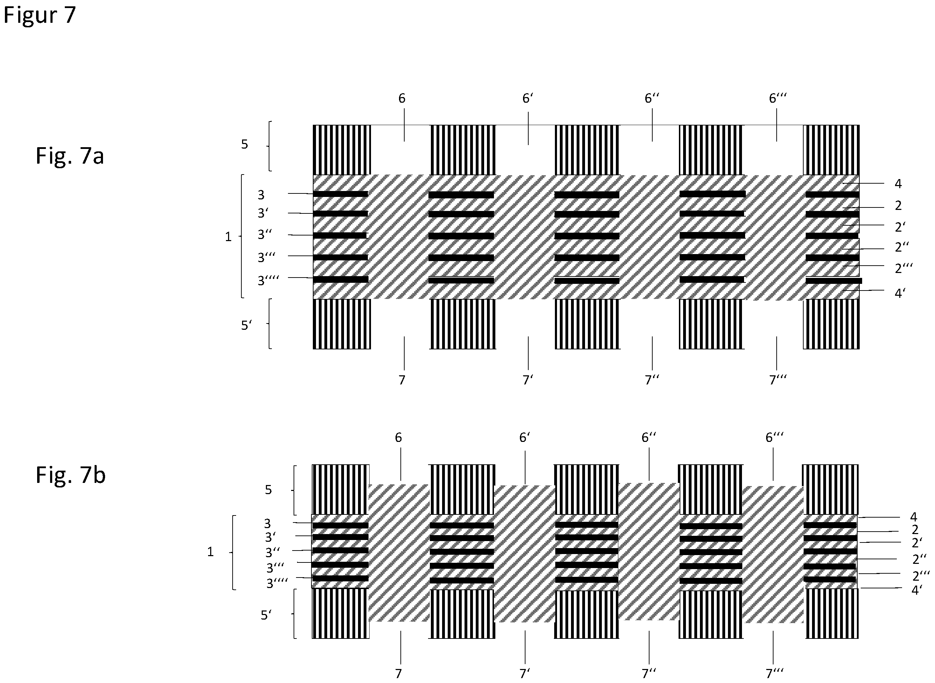

Figur 7a zeigt im Querschnitt den Aufbau eines erfindungsgemäßen elektromechanischen Wandlers mit einer dielektrischen Elastomerfolie 1, bestehend aus fünf leitfähigen Elektrodenschichten 3, 3', 3", 3"', 3"" und vier zwischen den Elektrodenschichten angeordneten nicht-leitfähigen Elastomerschichten und zwei nicht-leitfähigen Schutzschichten 4, 4', die die äußeren Elektrodenschichten 3 und 3"" einschließen. Weiterhin weist der elektromechanische Wandler zwei Strukturen 5, 5' mit kreisförmigen oberen Öffnungen 6, 6', 6", 6'''' und unteren Öffnungen 7, 7', 7", 7"" auf. Die fünf leitfähigen Elektrodenschichten 3, 3', 3", 3"', 3"" weisen auf den Flächensegmenten, auf denen sich die kreisförmigen oberen Öffnungen 6, 6', 6", 6"" und unteren Öffnungen 7, 7', 7", 7"" befinden, Aussparungen auf, wodurch sich die Elektrodenschichten auf die Flächensegmente konzentrieren, auf denen die dielektrische Elastomerfolie die Strukturen 5, 5' berührt.
Figur 7b zeigt im Querschnitt den erfindungsgemäßen elektromechanischen Wandler aus Figur 7a im komprimierten Zustand. Hier ist zu erkennen, dass die dielektrische Elastomerfolie auf den Flächensegmenten komprimiert wird, auf denen sich die Elektrodenschichten befinden

### Erfindungsgemäßes Beispiel 3

Figur 8 zeigt einen erfindungsgemäßen elektromechanischen Wandler mit langgestreckten Öffnungen 6, 6', 6", 6''' in der Struktur 5 in der Aufsicht.

### Erfindungsgemäßes Beispiel 4

Figur 9 zeigt einen erfindungsgemäßen elektromechanischen Wandler mit einer Struktur 5, die verschiedenen Öffnungen aufweist, in der Aufsicht. Neben kleineren Öffnungen 6, 6', 6", 6''' ist eine größere, zentrale Öffnung 8 vorhanden.

### Erfindungsgemäßes Beispiel 5

Figur 10 zeigt im Querschnitt einen erfindungsgemäßen elektromechanischen Wandler mit einer dielektrischen Elastomerfolie mit 4 Elektrodenfeldern in einer 2x2-Matrix zwischen 2 Strukturen mit kreisförmigen Öffnungen. Nur die vorderen 2 Elektrodenfelder sind in Figur 9 zu sehen.
Figur 11 zeigt den erfindungsgemäßen elektromechanischen Wandler aus Figur 9 in der Aufsicht mit einem Array aus vier Elektrodenfeldern 9, 9', 9", 9''' mit Öffnungen 6, 6', 6", 6"'.
Figur 12 zeigt im Querschnitt den erfindungsgemäßen elektromechanischen Wandler aus Figur 9 im komprimierten Zustand.
Figur 13 zeigt die Druckbelastungs- und Druckentlastungskurve eines elektromechanischen Wandlers mit 5 Elektrodenschichten, 4 Dielektrikumsschichten und 2 Schutzschichten zwischen starren Platten gemäß Figur 3 (Stand der Technik). Der elektromechanische Wandler zeigt eine geringe Kapazitätssteigerung bei der Druckbelastung und nur eine geringe Abnahme der Kapazität bei der Druckentlastung sowie eine starke Hysterese.
Figur 14 zeigt die Druckbelastungs- und Druckentlastungskurve eines elektromechanischen Wandlers mit fünf Elektrodenschichten, vier Dielektrikumsschichten und zwei Schutzschichten zwischen zwei flexiblen Strukturen aus Silicon mit kreisförmigen Löchern gemäß Figur 4. Der elektromechanische Wandler zeigt eine hohe Kapazitätssteigerung bei der Druckbelastung und eine nahezu vollständige Rückstellung der Kapazität auf den Anfangswert bei der Druckentlastung sowie eine geringe Hysterese.

### Erfindungsgemäßes Beispiel 6

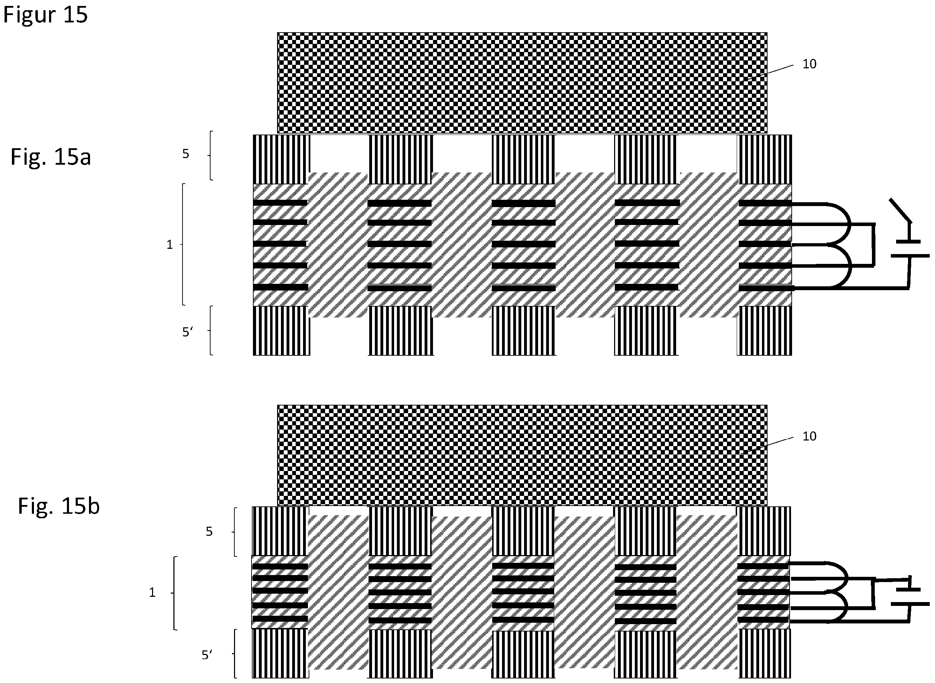

Figur 15 zeigt im Querschnitt einen erfindungsgemäßen elektromechanischen Wandler im Aktorbetrieb oder im Generatorbetrieb. Der Wandler besteht wie in Figur 4 aus einer dielektrischen Elastomerfolie 1, bestehend aus fünf leitfähigen Elektrodenschichten und vier zwischen den Elektrodenschichten angeordneten nicht-leitfähigen Elastomerschichten und zwei nicht-leitfähigen Schutzschichten, die die äußeren Elektrodenschichten einschließen. Weiterhin weist der elektromechanische Wandler zwei Strukturen 5, 5' mit kreisförmigen oberen Öffnungen und unteren Öffnungen auf. Die fünf Elektrodenschichten der dielektrischen Elastomerfolie 1 sind vorzugsweise zwischen den kreisförmigen oberen und unteren Öffnungen der zwei Strukturen 5, 5' unterbrochen.

Im Aktorbetrieb wird der elektromechanische Wandler mit einem Gewicht 10 belastet, das den Wandler komprimiert (Fig. 15a). An die fünf Elektrodenschichten wird eine elektrische Spannung mit alternierender Polarität angeschlossen (Fig. 15b). Durch die elektrostatische Anziehung der Elektrodenschichten wird die dielektrische Elastomerfolie 1 weiter komprimiert, wobei das verdrängte Material in die Öffnungen gedrückt wird (Fig. 15b) und wodurch sich das Gewicht absenkt. Beim Abschalten der Spannung dehnt sich die dielektrische Elastomerfolie 1 wieder aus, wodurch das Gewicht angehoben wird.

Im Generatorbetrieb erfolgt eine zyklische Belastung und Entlastung des elektromechanischen Wandlers sowie eine zyklische elektrische Beladung und Entladung der Elektroden des elektromechanischen Wandlers. Dabei wird die mechanische Kompressionsenergie teilweise in elektrische Energie umgewandelt.

## Patentansprüche

1. Elektromechanischer Wandler enthaltend
• mindestens eine dielektrische Elastomerfolie mit mindestens einer elektrisch nicht-leitfähigen Elastomerschicht und angrenzend an die Oberflächen der Elastomerschicht(en) mindestens zwei elektrisch leitfähigen Elektrodenschichten
• mindestens eine Erhöhungen und/oder Vertiefungen und/oder Öffnungen aufweisende, flächige Struktur, die flächig an der dielektrischen Elastomerfolie anliegt,
• mindestens zwei elektrische Zuleitungen zu den mindestens zwei Elektrodenschichten zur Messung der elektrischen Kapazität oder zur Anlegung einer elektrischen Spannung,
wobei der elektromechanische Wandler senkrecht zur Fläche der dielektrischen Elastomerfolie durch eine äußere Kraft bzw. einen äußeren Druck auf die Fläche kompressibel ist und über die Kompression sich die elektrische Kapazität verändert oder der elektromechanische Wandler sich beim Anlegen einer elektrischen Spannung zwischen den mindestens zwei Elektrodenschichten senkrecht zur Fläche der dielektrischen Elastomerfolie komprimiert.

2. Elektromechanischer Wandler nach Anspruch 1,
**dadurch gekennzeichnet, dass** die mindestens eine dielektrische Elastomerfolie mehr als eine elektrisch nicht-leitfähige Elastomerschicht und mehr als zwei elektrisch leitfähige Elektrodenschichten in alternierender Schichtfolge aufweist.

3. Elektromechanischer Wandler nach einem der Ansprüche 1 oder 2, **dadurch gekennzeichnet, dass** die dielektrische Elastomerfolie und die Erhöhungen und/oder Vertiefungen und/oder Öffnungen aufweisende flächige Struktur miteinander verbunden sind.

4. Elektromechanischer Wandler nach einem der Ansprüche 1 bis 3, **dadurch gekennzeichnet, dass** die leitfähigen Elektrodenschichten der mindestens einen dielektrischen Elastomerfolie sich nicht über die gesamte Fläche der dielektrischen Elastomerfolie erstecken, sondern bevorzugt auf den Flächensegmenten Aussparungen aufweisen, auf denen die dielektrischen Elastomerfolie die Erhöhungen und/oder Vertiefungen und/oder Öffnungen aufweisende, flächige Struktur nicht berührt.

5. Elektromechanischer Wandler nach einem der Ansprüche 1 bis 4, **dadurch gekennzeichnet, dass** sich bei der Kompression durch eine äußere Kraft bzw. einen äußeren Druck und/oder durch eine angelegte elektrische Spannung die dielektrische Elastomerfolie in der Fläche ungleichmäßig verformt, indem sie teilweise dünner und teilweise dicker wird.

6. Elektromechanischer Wandler nach einem der Ansprüche 1 bis 5, **dadurch gekennzeichnet, dass** die dielektrische Elastomerfolie zwischen zwei Strukturen angeordnet ist, wobei die Oberflächen der Strukturen mit den Erhöhungen und/oder Vertiefungen der dielektrischen Elastomerfolie zugewandt sind.

7. Elektromechanischer Wandler nach einem der Ansprüche 1 bis 6, **dadurch gekennzeichnet, dass** sich die Erhöhungen auf mindestens zwei benachbarten Strukturen mindestens teilweise überdecken und/oder die Vertiefungen auf mindestens zwei benachbarten Strukturen mindestens teilweise überdecken und/oder die Öffnungen auf mindestens zwei benachbarten Strukturen mindestens teilweise überdecken.

8. Elektromechanischer Wandler nach einem der Ansprüche 1 bis 7, **dadurch gekennzeichnet, dass** die Struktur eine Folie oder Platte ist und aus mindestens einem elektrisch nicht leitfähigen Material, bevorzugt aus einem elastomeren Material besteht oder dieses enthält.

9. Elektromechanischer Wandler nach einem der Ansprüche 1 bis 8, **dadurch gekennzeichnet, dass** das Material der mindestens einen Struktur eine größere Härte und/oder ein höheres E-Modul als die mindestens eine Elastomerschicht der dielektrischen Elastomerfolie aufweist, bevorzugt um mindestens einen Faktor 2, besonders bevorzugt um mindestens einen Faktor 4.

10. Elektromechanischer Wandler nach einem der Ansprüche 1 bis 9, **dadurch gekennzeichnet, dass** die Erhöhungen und/oder Vertiefungen und/oder Öffnungen eine kreisförmige und/oder eine eckige, insbesondere quadratische, und/oder eine langgestreckte Geometrie oder Kombinationen hiervon aufweisen.

11. Elektromechanischer Wandler nach einem der Ansprüche 1 bis 10, **dadurch gekennzeichnet, dass** die mindestens eine elektrisch nicht-leitfähige Elastomerschicht eine Dicke von 0,1 nm bis 5 mm, bevorzugt von 1 nm bis 2 mm, besonders bevorzugt von 5 nm bis 1 mm aufweist und/oder
die mindestens zwei elektrisch leitfähigen Elektrodenschichten jeweils eine Dicke von 0,1 nm bis 100 µm, bevorzugt von 1 nm bis 50 µm, besonders bevorzugt von 5 nm bis 30 µm aufweisen.

12. Elektromechanischer Wandler nach einem der Ansprüche 1 bis 11, **dadurch gekennzeichnet, dass** die mindestens eine dielektrische Elastomerfolie an mindestens einer Oberfläche eine elektrisch nicht-leitfähige Schutzschicht auf der äußeren elektrisch leitfähigen Elektrodenschicht der dielektrischen Elastomerfolie aufweist.

13. Elektromechanischer Wandler nach einem der Ansprüche 1 bis 12, **dadurch gekennzeichnet, dass** der elektromechanische Wandler mindestens zwei dielektrische Elastomerfolien aufweist, zwischen denen eine flächig an den dielektrischen Elastomerfolien anliegende Struktur mit Erhöhungen und/oder Vertiefungen und/oder Öffnungen angeordnet ist.

14. Elektromechanischer Wandler nach einem der Ansprüche 1 bis 13, **dadurch gekennzeichnet, dass** die Elektrodenschichten strukturiert sind und die elektrisch leitfähigen Bereiche als ein- oder zweidimensionale Arrays angeordnet sind.

15. Verwendung des elektromechanischen Wandlers nach einem der Ansprüche 1 bis 14 als Drucksensor, Dehnungssensor oder Verformungssensor oder Arrays hiervon, insbesondere zur Messung von flächigen Drücken oder Druckverteilungen, insbesondere auf oder in Sitzen, Betten, Matratzen, Schuhen, Teppichen, Regalen, Vitrinen, Fußböden oder in Dichtungen oder Schläuchen oder auf Lagern sowie als Aktor zum Anheben, Absenken und Verschieben von Objekten, zum Verstellen von Klappen, Spiegeln, optischen Elementen und Schaltern, zur Erzeugung von haptischer Rückmeldung oder zur Schwingungsminderung sowie als Generator zur Umwandlung von mechanischer Energie in elektrische Energie in Fußböden und Bauwerken wie z. B. Brücken, in Schuhen und anderen am Körper getragenen Gegenständen wie z. B. Bekleidung oder zur Nutzung von Wind- oder Meeresenergie.
